# EUROPEAN PATENT APPLICATION

(11) **EP 2 442 364 A1**
(43) Date of publication of application: **18.04.2012**
(21) Application number: 11789049.1
(22) Date of filing: 24.05.2011
(51) Int. Cl.: H01L 29/49, H01L 21/285, H01L 27/115

(54) **GATE STACK STRUCTURE FOR SEMICONDUCTOR FLASH MEMORY DEVICE AND PREPARATION METHOD THEREOF**

(30) Priority: 19.05.2011 CN 201110130484; 03.06.2010 CN 201010191659
(71) Applicant: Fudan University, Shanghai 200433 (CN)
(72) Inventor: DING, Shijin, Shanghai 200433 (CN); GOU, Hongyan, Shanghai 200433 (CN); ZHANG, Wei, Shanghai 200433 (CN)
(74) Representative: Thompson, Andrew John
(86) International application number: PCT/CN2011/000891
(87) International publication number: WO 2011/150670

(57) **Abstract**

The invention relates to a gate stack structure suitable for use in a semiconductor flash memory device and its fabricating method. The gate stack structure is fabricated on a p-type 100 silicon substrate, which also includes the following components in sequence from bottom to top: a charge tunnel layer of Al₂O₃ film, the first charge trapping layer of RuOₓ nanocrystals; the second charge trapping layer of high-k HfₓAl_{y}O_{z} film, a charge blocking layer of Al₂O₃ film, and a top electrode. In this invention, the RuOₓ nanocrystals have excellent thermal stability, and do not diffuse easily at high temperatures. The high-k HfₓAl_{y}O_{z} film has high density charge traps. Pd with a high work function is used as the top electrode. Therefore, the present gate stack structure has vast practical prospects for nanocrystal memory devices.

## Description

### Field of Invention

The present invention relates to the fabrication of semiconductor integrated circuits, and, particularly to an electric capacity structure and a fabricating method of a flash memory capacitor. More specifically, it relates to a gate stack structure and a fabricating method with a novel heterogenous charge storage layer composed of metal nanocrystals and high permittivity (high-k) dielectric .

### Background of Invention

With development of semiconductor process and technology, the integration density of nonvolatile flash memory becomes higher and higher, at the same time, the operating voltage becomes lower and lower. Therefore, these drive a continuous shrinkage of memory device. Beyond 65nm technology node, the conventional poly-silicon floating gate memory device will face many problems, thus the memory device performance will be affected, such as low programming/erasing speed, high operating voltage etc.

Recently, a new type of nonvolatile memory based on discrete-charge storage nodes (such as nanocrystal memory and SONOS-type memory etc) has drawn great attention. The aforementioned memory devices use discrete charge traps to store charges in place of continuous poly-silicon floating gate, which can prevent a loss of massive charges stored in the charge-trapping layer through local defects in the tunnel layer, thus efficiently enhancing the data retention of memory, and achieving lower operating voltage and higher programming/erasing speed.

Compared with semiconductor nanocrystals, metal nanocrystals have some advantages such as higher density of states around Fermi level, a wider range of work functions, stronger coupling with substrate channel and so on. Accordingly, the above mentioned advantages can ensure that the memory device has lower operating voltage, higher stored charge density and longer charge retention. Some research indicates that a deep potential well can be formed by using high work-function metal nanocrystals, thus efficiently trapping charges and offering better data retention.

On the other hand, with the development of the SONOS-type memories, it has been proposed that high-k materials are employed to replace the charge trapping layer of silicon nitride in the SONOS-type memory, which can enhance the electric field across the tunnel layer. This further increases programming and erasing speeds. However, relatively high operating voltages and slow operating speed are the major drawbacks of the SONOS-type memory.

### Summary of the Invention

The object of the present invention is to provide a gate stack structure for use in a semiconductor flash memory device, which has a high stored-charge density, a low operating voltage, fast programing and erasing speeds, as well as good charge retention. The other object of the present invention is to offer a method of fabricating the above-mentioned gate stack structure.

To achieve the above-mentioned objects, the present invention provides a gate stack structure for use in a semiconductor flash memory device and its fabricating method. Herein, the said gate stack structure contains a heterogeneous charge storage layer based on metal nanocrystals and high-k film. The aforementioned gate stack structure includes the following components in sequence from bottom to up:
A p-type (100) monocrystalline silicon wafer used as a substrate;
   an Al₂O₃ film with a thickness of 5∼15nm formed by ALD (atomic layer deposition) which serves as a charge tunnel layer;
   said heterogeneous charge storage layer further includes the following:
      said metal nanocrystals acting as a first charge trapping layer, which is a composite consisting of Ru and Ru oxide, denoted as RuOₓ nanocrystals;
      said ALD high-k film with a thickness of 3∼20nm acting as a second charge trapping layer, said high-k dielectric is HfₓAl_{y}O_{z}, where x>0, z>0 and y=0 or y>0;
   an Al₂O₃ film with a thickness of 15∼40nm formed by ALD, which serves as a charge blocking layer; and
   a top electrode layer.

The above-mentioned high-k film can be HfAlO, as an example, it may consist of HfO₂ and Al₂O₃ with a deposition cycle ratio of 1:1; Alternatively, said high-k film can be an HfO₂ film.

The aforementioned top electrode layer contains a gate electrode which is composed of metal palladium (Pd).

The fabricating method of the aforementioned gate stack structure includes the following steps:
Step 1, providing a p-type (100) monocrystalline silicon wafer as a substrate.
Step 2, growing an Al₂O₃ film with a thickness of 5∼15nm on the Si substrate by ALD (atomic layer deposition), which acts as a tunnel layer.
Step 3.1, depositing a 2∼4 nm Ru thin film on the Al₂O₃ tunnel layer using a magnetron sputtering technique, followed by rapid thermal annealing (RTA) in nitrogen environment, thus forming RuOₓ nanocrystals, which serve as the first charge trapping layer in the heterogeneous charge storage layer, the aforementioned RuOₓ nanocrystals being a composite of metal Ru and Ru oxide.
Step 3.2, growing a high-k HfₓAl_{y}O_{z} thin film with a thickness of 3∼20nm by ALD, which is used as the second charge-trapping layer in the heterogeneous charge storage layer, wherein for the aforementioned high-k HfₓAl_{y}O_{z} film, , x>0, , y=0 or y>0. Herein, the atomic contents of Hf and Al can be determined by deposition cycles of HfO₂ and Al₂O₃;
Step 4, growing a 15∼40nm film of Al₂O₃ by ALD, which acts as a charge blocking layer, followed by rapid thermal annealing;
Step 5, forming a gate electrode with a thickness of 50∼200 nm by lithography and lift-off process, which serves as the top electrode layer.

The high-k HfₓAl_{y}O_{z} film described in Step 3.2 can be HfAlO, which consists of HfO₂ and Al₂O₃ with a deposition cycle ratio of 1:1. Alternatively, the said high-k HfₓAl_{y}O_{z} film can be HfO₂ .

As described in step 3.2, the experimental conditions for ALD (atomic layer deposition) of HfO₂ film are as follows: the substrate temperature is kept at 250∼350°C, and the reaction precursors include tetrakis(ethylmethylamino)-hafnium (TEMAH) and water vapor.

As described in step 2, step 3.2 and Step 4, the experimental conditions for ALD of Al₂O₃ film are as follows: the substrate temperature is kept at 250∼350°C, and the reaction precursors include trimethylaluminium (TMA) and water vapor.

As described in Step 3.1, the annealing temperature for the formation of RuOₓ nanocrystals is 700∼900°C, and the annealing time is 10-30s. In step 4, said rapid thermal annealing is carried out at 500∼800°C for 10-30s during the formation of the Al₂O₃ charge blocking layer.

In Step 5, the gate electrode material is a metal of Pd.

The aforementioned fabricating method also includes:
Step 6, removing the native oxide on the back side of silicon substrate using diluted HF solution, and then depositing an Al layer as a bottom electrode in order to form a good ohmic contact.

The gate stack structure for use in a semiconductor flash memory device of the present invention and its fabricating method have the following advantages as follows:
1. Depositing ultra-thin metallic Ru films using magnetic sputtering technique allows. the thickness and deposition rate of the film to be controlled precisely by optimizing sputtering power, deposition time and substrate temperature etc in high vacuum, thereby forming ultra-thin and uniform metal films. This makes it easier to form small dimensional, uniformly distributed and high density nanocrystals.
2. The RuOₓ nanocrystals are used to form the first charge trapping layer as the charge storage center, which can achieve a large depth of potential well due to a high work function of 4.7-5.2eVThis helps to improve the charge storage capability. In the present invention, the formation temperature of the RuOₓ nanocrystals is compatible with the process temperature of the memory devices, which does not exceed the annealing temperature for source and drain activation after ion implantation during device fabrication.
3. The high-k HfₓAl_{y}O_{z} material is introduced as the second charge trapping layer, which can effectively enhance the electric field across the tunnel layer due to its high dielectric constant of 10∼25. This will increase the programming and erasing speeds of the memory device, and reduce the operating voltage. Furthermore, the HfₓAl_{y}O_{z} material can offer enough charge traps for charge storage.
4. The heterogeneous charge storage layer composed of high-k HfₓAl_{y}O_{z} and high density RuOₓ nanocrystals can jointly trap charges injected from the substrate. This greatly increases the density of the stored charges. Moreover, the combination of high density RuOₓ nanocrystals with HfₓAl_{y}O_{z} film effectively restrains crystallization of HfₓAAl_{y}O_{z} dielectric after high temperature annealing, thus reducing charge leakage along grain boundaries and enhancing charge retention of the memory device.
5. ALD is used to deposit the HfₓAl_{y}O_{z} film. This can not only control the composition and thickness of the film accurately, but also effectively fill a nano-scale gap. Therefore, the RuOₓ nanocrystals can be isolated completely by HfₓAl_{y}O_{z} dielectric.
6. Pd is used as an electrode, which can, together with the blocking Al₂O₃ layer, form a barrier helpful to programming and erasing. It also ensures good chemical and thermal stabilities due to immunity to oxidation. Furthermore, Pd film is deposited on the Al₂O₃ film by electron beam evaporation in a high vacuum, thereby resulting in good contact between Pd and Al₂O₃. This can improve the performance of the memory capacitor.

Accordingly, the gate stack structure provided by the present invention will be very promising for next generation flash memory devices.

### Brief Description of the Drawings

FIG. 1 shows a cross-sectional view of the gate stack structure of memory capacitor with a heterogeneous charge storage layer of RuOₓ nanocrystals and high-k HfₓAl_{y}O_{z} film.
Fig. 2 shows flat-band voltages resulting from programming and erasing of the fabricated memory capacitors with different heterogeneous charge storage layer under different voltages for 0.1ms.
FIG. 3 shows the resulting flat-band voltages after programming under +9V and erasing under -9V of the fabricated memory capacitors with different heterogeneous charge storage layer for different times..
FIG. 4 shows the charge retention characteristics of the fabricated memory capacitors with different heterogeneous charge storage layer after programming at +9V and erasing at -9V for 1ms, respectively.

### Detailed Description of the Embodiments

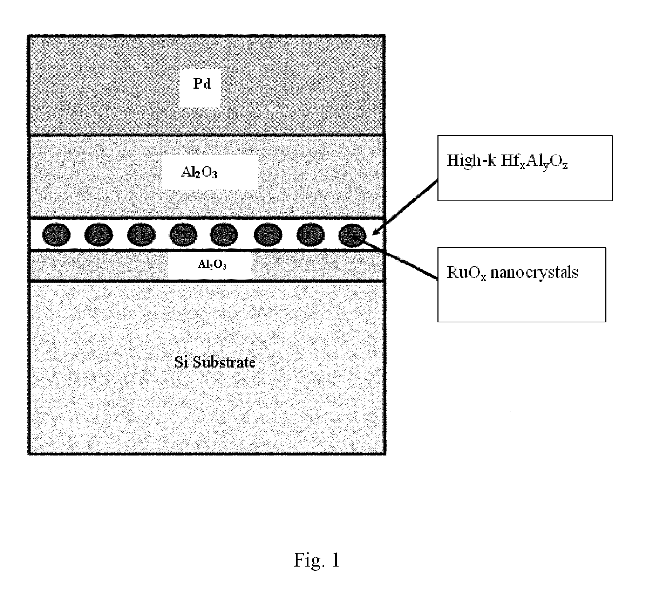

Referring to FIG. 1, the present invention relates to a gate stack structure for use in a semiconductor flash memory device, in particular, the related gate stack structure contains a heterogeneous charge storage layer consisting of metal nanocrystals and high-k film. Said flash memory capacitor includes the following components in sequence from bottom to top:
(1) A p-type monocrystalline silicon wafer with orientation 100 used as a substrate;
(2) An Al₂O₃ film with a thickness of 5∼15nm grown on the silicon substrate by atomic layer deposition, which acts as a tunnel layer;
(3) Said heterogeneous charge storage layer further includes:
   metal nanocrytsals acting as a first charge trapping layer, which is consisting of Ru and Ru oxide (denoted by RuOₓ nanocyrstals);
   a high-k film with a thickness of 3∼20 nm (preferred thickness is 5∼10nm) grown by ALD acting as a second charge trapping layer, the dielectric of said high-k is HfₓAl_{y}O_{z}, (x>0, z>0 and y=0 or y>0); the dielectric constant being 10∼25.
(4) An Al₂O₃ film with a thickness of 15∼40nm film grown by ALD, which acts as a charge blocking layer.
(5) A top electrode layer containing a gate electrode made of metal Pd. The above-mentioned gate stack structure for use in a semiconductor flash memory device contains a heterogeneous charge storage layer, which can be fabricated as follows:
   Step 1, providing A p-type 100 silicon wafer with a resistivity of 8∼12 Ω.cm as a substrate. Firstly, the silicon wafer is cleaned with a standard method, and the residual native oxide is removed by diluted HF solution.
   Step 2, growing a charge tunnel layer of Al₂O₃ by ALD using the precursors of trimethylaluminium and H₂O at 250∼350°C. The thickness of the Al₂O₃ layer is controlled in a range of 5∼15nm.
   Step 3.1, forming the RuOₓ nanocrystals of the heterogeneous charge storage layer: an ultra-thin Ru film with a thickness of 2∼4nm is deposited on the Al₂O₃ tunnel layer by magnetic sputtering, followed by rapid thermal annealing in N₂ environment at 700∼900°C for 10∼30s. The resulting RuOₓ nanocrystals are used as the first charge trapping layer.
   Step 3.2, forming a high-k HfₓAl_{y}O_{z} film of the heterogeneous charge storage layer by ALD, which is used as the second charge trapping layer.

One form of said HfₓAl_{y}O_{z} film is composed of HfO₂ and Al₂O₃ with a deposition cycle ratio of 1:1, denoted by HfAlO. Another form of said HfₓAl_{y}O_{z} film is a pure HfO₂ film without incorporation of Al₂O₃.

As for the above-mentioned two forms of HfₓAl_{y}O_{z} film, the temperature of the substrate is kept at a range of 250∼350°C, and the precursors for HfO₂ include Tetrakis (ethylmethylamino) Hafnium (TEMAH) and water vapor. The formation of Al₂O3 is as described in Step 2.

The thickness of HfAlO or HfO₂ film is controlled in a range of 3∼20 nm (preferred thickness is 5∼10 nm). Based on the difference of HfₓAl_{y}O_{z} film thickness, it is found that the HfₓAl_{y}O_{z} film can be present between nanocrystals when it is thin, but it cannot completely fill the gap between the nanocrystals. Otherwise, it can fill the gap between the nanocrystals completely when it is thick, as shown in Fig. 1.
Step 4. forming the charge blocking layer of Al₂O₃: firstly, a 15∼40nm film of Al₂O₃ is grown by ALD, which acts as a charge blocking layer, the conditions for the ALD are as follows: the substrate temperature is kept at 250∼350°C, and the precursors include trimethylaluminium and water vapor. And then the resulting sample is treated by rapid thermal annealing in N₂ environment at 500∼800°C for 10∼30s. This aims to acquire high quality Al₂O₃ blocking layer to restrain charges leaking.
Step 5. forming a top electrode by a lift-off technique. That is, the electrode pattern is firstly formed by lithography, and then a Pd film with a thickness of 50-200nm is deposited by electron beam evaporation. Finally, the remaining photoresist is removed by acetone.
Step 6. For electrical measurements of the device, the native oxide on the back of the silicon substrate is removed by diluted HF solution, and then a layer of Al is deposited on it, which serves as a bottom electrode to ensure a good ohmic contact. Hereto, the fabricating process of the aforementioned gate stack structure with a heterogeneous charge storage layer is completed.

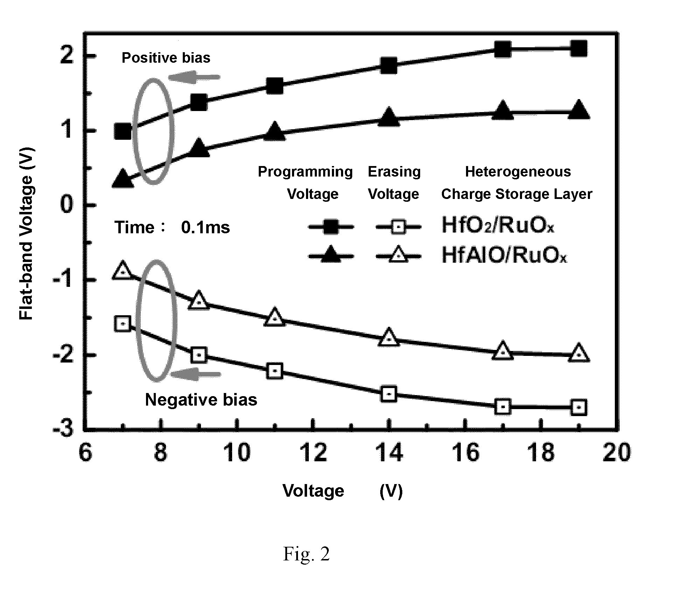

Fig. 2 shows the flat-band voltages resulting from programming and erasing of the fabricated memory capacitors with different heterogeneous charge storage layer under different voltages for 0.1ms, respectively, . As the programming voltage (positive bias) increases, the resulting flat-band voltage shifts gradually towards a positive bias, and this is due to negative charge trapping caused by electron injection. As the erasing voltage (negative bias) increases, the resulting flat-band voltage moves gradually in the direction of negative bias, which is attributed to de-trapping of the negative charges stored in the charge storage layer or injection of holes from the substrate. Furthermore, it is observed that the heterogeneous charge storage layer of RuOₓ/HfO₂ can provide a larger memory window than RuOₓ/HfAlO in the case of identical operating voltages. As an example, the former can result in a memory window of 2.6V, and the latter can lead to a memory window of 1.4V in the case of a 6V operating voltage.

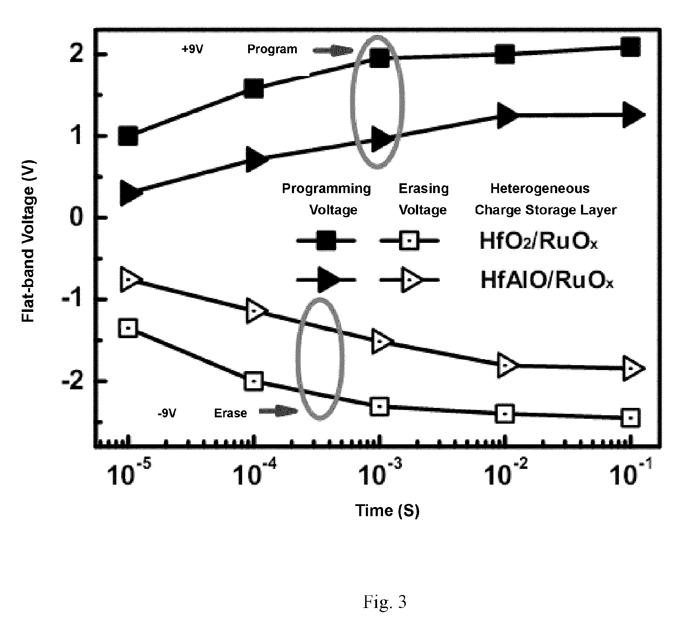

FIG. 3 shows the resulting flat-band voltages after programming under +9V and erasing under -9V of the fabricated memory capacitors with different heterogeneous charge storage layer for different times. It is seen that the resulting flat-band voltage increases with time under programming and erasing modes and finally tends to saturation. Regarding 0.1ms programming/erasing time, a memory window of around 2V was achieved for the RuOₓ/HfAlO charge storage layer-based capacitor, and a memory window of 3.5V was obtained for the RuOₓ/HfO₂ charge storage layer-based capacitor. Therefore, both of the capacitors exhibit fast programming and erasing characteristics under low operating voltages.

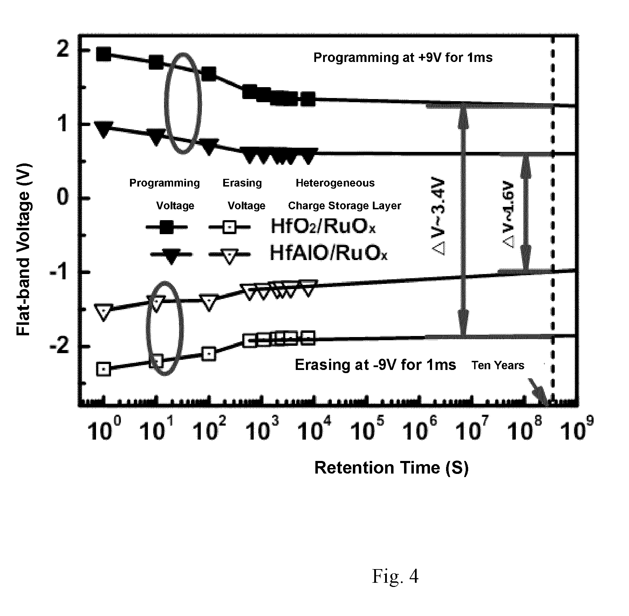

Fig. 4 shows the retention characteristics of the fabricated memory capacitors with the heterogeneous charge storage layer-based gate stack structure after programming at +9V for 1ms and erasing at -9V for 1ms, respectively. In terms of the charge trapping dielectric of HfO₂, the resulting memory window is close to 3.4V after ten years by extrapolation, thus exhibiting excellent charge retention. As for the charge trapping dielectric of HfAlO, the corresponding memory window is around 1.6V.

The aforementioned results indicate that the memory capacitors based on the heterogeneous charge storage layer of RuOₓ and HfₓAl_{y}O_{z} exhibit fast programming and erasing characteristics under low voltages as well as excellent charge retention.

To sum up, the present invention combines the advantages of both metal nanocrystals and high-k dielectrics, which act as the heterogeneous charge storage layer in the gate stack structure. The utilization of this kind of heterogeneous charge storage layer containing high-k dielectrics enhances the electric field across the charge tunnel layer, thus leading to a decrease in the potential barrier for charge injection, an increase in programming and erasing speeds and achievement of low operating voltages. Meanwhile, the metal nanocrystals with a high work function can result in the formation of a deeper potential well, which can ensure good charge retention after charges trapping.

The metal nanocrystals in the present invention are composed of Ru and Ru oxide (denoted by RuOₓ nanocrystals), which have excellent thermal stability. Though Ru is oxidized, it is still a good conductor. In addition, it does not diffuse easily at high temperature, and it is easy for dry etching.

The high-k dielectrics of HfₓAl_{y}O_{z} (y=0 or y>0) in the present invention have a dielectric constant of 10∼25 and high density of charge traps. These enable HfₓAl_{y}O_{z} to act as an ideal charge trapping layer instead of silicon nitride.

The top electrode of Pd in the present invention has a high work function of 5.22eV, and thus it combines with the charge blocking layer, resulting in a potential barrier propitious to programming and erasing. In addition, Pd has good chemical and thermal stabilities.

As a result, the gate stack structure provided by the present invention will be very promising for next generation flash memory devices.

Although the invention has been described with respect to specific embodiments for a complete and clear disclosure, the appended claims are not to be thus limited but are to be construed as embodying all modifications and alternative constructions that may occur to one skilled in the art that fairly fall within the basic teaching herein set forth. Therefore, the protection scope of the present invention should be determined by the attached claims.

## Claims

1. A gate stack structure for use in a semiconductor flash memory device comprising a heterogeneous charge storage layer based on metal nanocrystals and a high-k film; said gate stack structure comprising the following components in sequence from bottom to top,
a p-type monocrystalline silicon wafer with orientation 100 used as a substrate;
an Al₂O₃ film having a thickness of 5∼15nm grown on the silicon substrate by atomic layer deposition (ALD), which acts as a tunnel layer;
wherein said heterogeneous charge storage layer further includes:
said metal nanocrystals acting as a first charge trapping layer, which is a composite consisting of Ru and Ru oxide, denoted by RuOₓ nanocrystals;
said high-k film with a thickness of 3∼20nm grown by ALD acting as a second charge trapping layer, the dielectric of said high-k is HfₓAl_{y}O_{z}, where x>0, z>0 and y=0 or y>0;
an Al₂O₃ film with a thickness of 15∼40nm film grown by ALD, which acts as a charge blocking layer; and
a top electrode layer.

2. The gate stack structure for use according to claim 1, wherein said high-k film is a film of HfAlO consisting of HfO₂ and Al₂O₃ with a deposition cycle ratio of 1:1, or said high-k film is a pure HfO₂ film.

3. The gate stack structure for use according to claim 1, wherein said top electrode contains a gate electrode of metal Pd.

4. A method of producing a gate stack structure for use in a semiconductor flash memory device comprising the following steps:
step 1, providing a p-type monocrystalline silicon wafer with orientation 100 as a substrate;
step 2, growing an Al₂O₃ film with a thickness of 5∼15nm on the silicon substrate by ALD, which acts as a tunnel layer;
step 3.1, depositing a Ru film with a thickness of 2∼4nm on the Al₂O₃ tunnel layer by magnetic sputtering, followed by rapid thermal annealing in N₂ environment, thus forming RuOₓ nanocrystals, said resulting RuOₓ nanocrystals serving as the first charge trapping layer in the heterogeneous charge storage layer, wherein said RuOₓ nanocrystals are a composite consisting of Ru and Ru oxide;
step 3.2, growing a high-k HfₓAl_{y}O_{z} film with a thickness of 3∼20nm by ALD, said high-k HfₓAl_{y}O_{z} acting as the second charge trapping layer in the heterogeneous charge storage layer, wherein for the said high-k HfₓAl_{y}O_{z} film, x>0, z>0,and, y=0 or y>0, and wherein the atomic compositions of Hf and Al are determined by deposition cycles of HfO₂ and Al₂O₃;
step 4, growing a 15∼40nm film of Al₂O₃ by ALD, which acts as a charge blocking layer, followed by rapid thermal annealing;
step 5, forming a gate electrode with a thickness of 50∼200nm, which acts as the top electrode layer, by lithography and lift-off processes.

5. The method of claim 4, wherein said high-k HfₓAl_{y}O_{z} film described in step 3.2 is an HfAlO film, which is composed of HfO₂ and Al₂O₃ with a deposition cycle ratio of 1:1; or, said high-k HfₓAl_{y}O_{z} film is a pure HfO₂ film.

6. The method of claim 5, wherein the conditions for ALD of HfO₂ film described in step 3.2 are as follows: the substrate temperature is kept at 250∼350°C, and the precursors of said deposition include Tetrakis (ethylmethylamino) Hafnium and water vapor.

7. The method of claim 4 or 5 or 6, wherein, said conditions for ALD of Al₂O₃ film described in step 2, step 3.2 or step 4 are as follows: the substrate temperature is kept at 250∼350°C, and the precursors of said deposition include trimethylaluminium and water vapor.

8. The method of claim 4, wherein, in step 3.1, the annealing temperature for the formation of RuOₓ nanocrystals is 700∼900°C, and the annealing time is 10-30s; in step 4, said rapid thermal annealing is carried out at 500∼800°C for 10∼30s.

9. The method of claim 4, wherein, in step 5, the material of the gate electrode is metal Pd.

10. The method of claim 4, further comprising:
step 6, firstly removing the native oxide layer on the back of silicon wafer using diluted HF solution, and then depositing an Al layer as a bottom electrode in order to form a good ohmic contact.
